# EUROPÄISCHE PATENTSCHRIFT

(11) **EP 0 795 927 B1**
(45) Veröffentlichungstag und Bekanntmachung des Hinweises auf die Patenterteilung: **30.10.2002**
(21) Anmeldenummer: 96118960.2
(22) Anmeldetag: 27.11.1996
(51) Int. Cl.: H01Q 17/00

(54) **Elektromagnetische Wellen absorbierender Fassadenaufbau von Gebäuden**
Facade cover for buildings absorbing electromagnetic waves
Revêtement de façade pour des bâtiments absorbant d'ondes électromagnétiques

(30) Priorität: 15.03.1996 DE 19610197
(43) Veröffentlichungstag der Anmeldung: 17.09.1997
(73) Patentinhaber: EADS Deutschland GmbH, 81663 München (DE)
(72) Erfinder: Frye, Andreas, Dr., 28816 Stuhr (DE); Gerke, Heimfrid, Dr., 28199 Bremen (DE)

(56) Entgegenhaltungen:
- EP-A- 0 397 967
- EP-A- 0 405 077
- EP-A- 0 443 564
- EP-A- 0 456 554
- EP-A- 0 677 888
- DE-U- 9 316 963
- US-A- 5 146 047
- PROCEEDINGS OF THE INTERNATIONAL SYMPOSIUM ON ELECTROMAGNETIC COMPATIBILITY, DALLAS, AUG. 9 - 13, 1993, Nr. -, 9.August 1993, INSTITUTE OF ELECTRICAL AND ELECTRONICS ENGINEERS, Seite 168/169 XP000427678 IYER V R ET AL: "A TITANIUM-DIOXIDE BASED CERAMIC COMPOSITE DISPERSED WITH CONDUCTING INCLUSIONS AS AN EMI SHIELDING MATERIAL"

## Beschreibung

Die Erfindung betrifft einen Fassadenaufbau von Gebäuden zur Reflexion von Radarwellen nach dem Oberbegriff des Patentanspruchs 1.

Aus der EP-A1-0 405 077 ist ein Fassadenaufbau für Hochbauten bekanntgeworden, bei dem eine reflektierende Fläche auf der Gebäudewand vorgesehen ist. Im Abstand von etwa ¼ der Wellenlänge der auftreffenden elektromagnetischen Wellen ist eine elektrische Widerstandsschicht mit einem Flächenwiderstand im Bereich von 300 bis 1200 Ω/□ angeordnet. Diese Widerstandsschicht wird auf der Fassadenaußenschale angebracht, die aus einem Material mit geringer Transmissionsdämpfung besteht Diese Bauweise hat sich im praktischen Betrieb bewährt, sie weist jedoch den Nachteil auf, daß neben der ohnehin benötigten Fassadenaußenschale noch weitere elektrische Funktionselemente wie beispielsweise die auf der Gebäudewand angebrachte reflektierende Fläche installiert werden müssen. Im Bauwesen ist jeodch das Bestreben, auch bei radarabsorbierenden Fassaden die Bauweise so einfach wie möglich zu gestalten.

Aus der EP-A2-0443564 ist ein Fassadenaufbau mit einer keramischen Platte vor einer Gebäudewand bekannt, die auf ihrer Rückseite mit einer elektrischen Widerstandsschicht versehen ist. Zwischen der keramischen Platte und der Gebäudewand ist eine elektromagnetische Wellen vollständig reflektierende Fläche vorgesehen. Die keramische Platte läßt aufgrund ihrer relativ geringen Dicke Radarstrahlen weitgehend ungedämpft hindurch. Diese werden an der reflektierenden Fläche reflektiert. Diese reflektierten Wellen werden im Zusammenwirken mit den von der Fassadenschicht reflektierten Wellen ausgelöscht.

Es ist die Aufgabe der Erfindung, einen radarabsorbierenden Fassadenaufbau von Gebäuden bereitzustellen, bei dem eine Reflexionsunterdrückung nach dem Interferenzprinzip weitgehend unabhängig von der Gestaltung und der Anordnung der Gebäudewand relativ zum Fassadenaufbau erfolgt. Die Lösung dieser Aufgabe erfolgt erfindungsgemäß dadurch, daß die Widerstandsschicht einen Flächenwiderstand im Bereich von 10 bis 300 Ω/□ aufweist und daß die Fassadenschicht aus einem Baustoff mit der Dicke von etwa 1/10 bis 1/3 der Wellenlänge der elektromagnetischen Wellen im Baustoff besteht. Weitere vorteilhafte Ausgestaltungen des Fassadenaufbaus sind in den Unteransprüchen beschrieben.

Der besondere Vorteil der vorgeschlagenen radarabsorbierenden Fassadenbauweise ist darin zu sehen, daß sie sich von einer nichtabsorbierenden Bauweise nur noch durch die Anordnung der elektrischen Widerstandsschicht unterscheidet. Als Fassadenaußenschale können die sonst üblichen Baustoffe wie Ziegel, Keramik, Glas, Natur- oder Sandstein oder auch Schichtpreßstoffe oder Faserverbundwerkstoffe Verwendung finden. Somit werden die baubehördlichen Auflagen und die architektonischen Anforderungen an das Erscheinungsbild der Fassade erfüllt.

In der Zeichnung sind Ausführungsbeispiele der Erfindung schematisch vereinfacht dargestellt. Es zeigen:
- Fig. 1: einen Schnitt durch einen Fassadenaufbau;
- Fig. 2: einen Schnitt durch einen Fassadenaufbau in erweiterter Form.

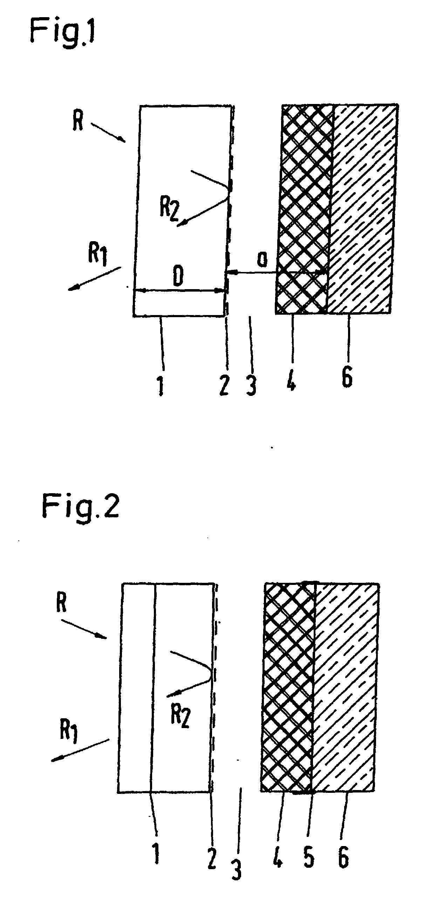

Bei dem Ausführungsbeispiel gemäß Fig. 1 ist eine Fassadenschicht 1 vor einer Gebäudewand 6 in einem Abstand a aufgehängt. Innerhalb des Abstandes a ist eine Luftschicht 3 und eine wärmedämmende Isolationsschicht 4 vorgesehen. Auf der der Gebäudewand 6 zugewandten Innenseite der Fassadenschicht 1 ist eine elektrische Widerstandsschicht 2 angebracht.

Diesem Fassadenaufbau liegt die Erkenntnis zugrunde, daß auf eine zusätzliche reflektierende Schicht, die bei den bisher üblichen Fassadenbauweisen auf der Gebäudewand 6 befestigt war, verzichtet werden kann, wenn eine elektrische Widerstandsschicht 2 mit einem Flächenwiderstand im Bereich zwischen 10 und 300 Ω/□ verwendet wird. Zusätzlich werden die physikalischen Parameter der Fassadenschicht 1 genutzt, um eine Interferenzlöschung der einfallenden elektromagnetischen Welle R zu erreichen. Die physikalischen Parameter der elektrischen Widerstandsschicht 2 werden an das vorgegebene Fassadenmaterial angepaßt. Die Absorptionsfähigkeit der Kombination aus Fassadenverkleidungswerkstoff und elektrischer Widerstandsschicht wird wesentlich durch die Schichtdicke der Fassadenverkleidung und durch die qualitativen Eigenschaften der elektrischen Widerstandsschicht bestimmt. Als Material für die Fassadenschicht 1 wird ein Baustoff gewählt, dessen Dicke D mit Hinblick auf den zu absorbierenden Frequenzbereich der einfallenden elektromagnetischen Wellen etwa 15 bis 80 mm beträgt. Der Baustoff selbst weist eine mittlere bis hohe Dielektrizität und Permeabilität auf. Daraus ergeben sich niedrige bis mittlere dielektrische Verluste für die den Baustoff durchlaufenden Wellenanteile.

Die erwünschte Reflexionsunterdrückung der einfallenden elektromagnetischen Welle R läuft folgendermaßen ab. Eine Radarwelle R im Frequenzbereich von etwa 1 Ghz trifft in einem bestimmten Winkelbereich auf die außenseitige Oberfläche der Fassadenschicht 1 auf. Aufgrund der Oberflächenreflektivität des Baustoffes wird ein bestimmter Anteil R₁ der Welle R an der Außenseite der Fassade reflektiert. Der in den Baustoff der Fassade 1 eindringende Anteil R₂ unterliegt der Transmissionsdämpfung des Fassadenmaterials, die bei der gegebenen Materialdicke D etwa eine Größenordnung von 5 bis 40 % hat. Der eindringende Wellenanteil R₂ erreicht die elektrische Widerstandsschicht 2 und wird dort aufgrund des niedrigen Flächenwiderstandes reflektiert. Der zurückgeworfene Wellenanteil R₂ weist beim Wiederaustritt aus der Fassadenschicht 1 eine Phasenverschiebung von etwa λ/2 gegenüber dem unmittelbar reflektierten Wellenanteil R₁ auf, so daß eine Interferenzauslöschung eintritt, die die Reflexion der Fassade weitgehend unterdrückt. In der Praxis wird bei Frequenzen um 1 Ghz eine Reflexionsdämpfung von mindestens 20 dB erzielt. Das heißt, daß weniger als 1 % der einfallenden Energie wieder reflektiert wird.

Die elektrische Widerstandsschicht 2 weist eine sehr geringe Durchlässigkeit auf, die den in die Fassadenschicht 1 eindringenden Wellenanteil R₂ betrifft. Die sich daraus ergebenden Rückwirkungen beeinflussen jedoch nicht die Reflexionsdämpfungseigenschaften der Fassadenverkleidung. Aus diesem Grund ist es möglich, das Isoliermaterial 4 - wie in Fig. 2 dargestellt - in Metallkassetten 5 zu fassen, die der Gebäudewand 6 vorgehängt werden. Dies beeinflußt die Absorptionsfähigkeit des Fassadenaufbaus ebensowenig wie die tatsächliche Reflexionsfähigkeit der Gebäudewand 6.

Die Fassadenschicht 1 ist gemäß Fig. 1 einschichtig ausgeführt. Sie kann aber auch, wie in Fig. 2 gezeigt, zwei- oder mehrschichtig als Sandwichelement gefertigt sein. Als Baustoff für die Fassadenschicht eignen sich Natur- oder Sandstein genausogut wie Ziegel, Keramiken oder Glas. Alternativ sind auch Fassadenplatten aus einem Schichtpreßstoff, der aus mit Kunstharz imprägnierten verpreßten Zellulosefäden besteht, oder aus einem Faserverbundwerkstoff verwendbar.

Die elektrische Widerstandsschicht kann aus einem mit leitfähigem Material ausgerüsteten Vlies bestehen. Alternativ wird das Vlies selbst aus elektrisch leitfähigen Fasern hergestellt oder es wird mittels im Vliesmaterial inkorporierten Rußes eine Widerstandsschicht erzeugt. Schließlich kann die Widerstandsschicht durch einen Film aus elektrisch und/oder magnetisch leitfähigen Metallpartikeln gebildet werden.

Mit dem beschriebenen Fassadenaufbau werden Gebäude verkleidet, die große geometrische Abmessungen und damit großflächige ebene oder gekrümmte Konturen aufweisen. Diese Fassadenbauweise ist besonders für Gebäude geeignet, die in unmittelbarer Nähe von Richtfunkanlagen oder Flugsicherungseinrichtungen (Airport Surveillance Radar) stehen. Mit Hilfe der Verkleidung dieser Gebäude werden Radarreflexionen vermieden, die die Übertragungsqualität von Richtfunkstrecken bzw. die Funktion einer Flugsicherungsanlage bei der Flugzeugidentifikation und -führung empfindlich beeinträchtigen würden.

## Patentansprüche

1. Fassadenaufbau von Gebäuden zur Reflexion von Radarwellen mit einer im Abstand zur Gebäudewand angeordneten Fassadenschicht und einer im Bereich der Fassadenschicht angeordneten elektrischen Widerstandsschicht,
**dadurch gekennzeichnet,**
**daß** die Widerstandsschicht (2) auf der Innenseite der Fassadenschicht (1) aufgebracht ist und einen Flächenwiderstand im Bereich von 10 bis 300 Ω/□ aufweist und
**daß** die Fassadenschicht (1) eine Dicke (D) zwischen 15 und 80 mm aufweist und eine Dielektrizitätskonstante zwischen 3 < εᵣ < 100 sowie eine Permeabilität zwischen 1 < µᵣ < 10 aufweist, um die an der Fassaden-Außenseite und der Fassaden-Rückseite entstehenden Reflexionen gegeneinander auszugleichen.

2. Fassadenaufbau nach dem Anspruch 1, **dadurch gekennzeichnet, daß** als Baustoff die Fassadenschicht (1) keramisches Material oder Glas verwendet wird.

3. Fassadenaufbau nach einem der voranstehenden Ansprüche, **dadurch gekennzeichnet, daß** als Baustoff die Fassadenschicht (1) Ziegel, Naturstein oder Sandstein verwendet wird.

4. Fassadenaufbau nach einem der voranstehenden Ansprüche, **dadurch gekennzeichnet, daß** als Baustoff die Fassadenschicht (1) Faserzement verwendet wird.

5. Fassadenaufbau nach einem der voranstehenden Ansprüche, **dadurch gekennzeichnet, daß** als Baustoff die Fassadenschicht (1) ein Schichtpreßstoff aus mit Kunstharzen imprägniertem und verpreßtem Zellulosematerial verwendet wird.

6. Fassadenaufbau nach einem der voranstehenden Ansprüche, **dadurch gekennzeichnet, daß** die elektrische Widerstandsschicht (2) aus einem mit elektrisch leitfähigem Material ausgerüsteten Vlies oder einem textilen Flächengebilde besteht.

7. Fassadenaufbau nach einem der voranstehenden Ansprüche, **dadurch gekennzeichnet, daß** die elektrische Widerstandsschicht (2) durch ein Vlies mit inkorporiertem Ruß gebildet ist.

8. Fassadenaufbau nach einem der voranstehenden Ansprüche, **dadurch gekennzeichnet, daß** die elektrische Widerstandsschicht (2) ein Vlies aus elektrisch leitfähigen Fasern ist.

9. Fassadenaufbau nach einem der voranstehenden Ansprüche, **dadurch gekennzeichnet, daß** die elektrische Widerstandsschicht (2) aus einem Film aus elektrisch leitfähigen und/oder magnetischen Materialpartikeln besteht.

10. Fassadenaufbau nach einem der voranstehenden Ansprüche, **dadurch gekennzeichnet, daß** die Fassadenschicht (1) aus einem Sandwich-Element gebildet ist.

11. Fassadenaufbau nach wenigstens einem der voranstehenden Ansprüche, **dadurch gekennzeichnet, daß** im Bereich zwischen der Gebäudewand (6) und der Fassadenschicht (1) Wärmedämm-Material (4) angeordnet ist.

12. Fassadenaufbau nach wenigstens einem der voranstehenden Ansprüche, **dadurch gekennzeichnet, daß** auf der Gebäudewand (6) Metallkassetten (5) zur Aufnahme und Halterung von Isoliermaterial (4) angebracht sind.

## Claims

1. Façade cover for buildings for reflecting radar waves, having a facade layer arranged at a distance from the building wall and an electrical resistor layer arranged in the vicinity of the facade layer, **characterised in that** the resistor layer (2) is applied to the inside of the facade layer (1) and has a surface resistivity in the range of between 10 Ω/ and 300 Ω/ and that the facade layer (1) has a thickness (D) of between 15 mm and 80 mm and a dielectric constant of 3 < εᵣ < 100 and a permeability of 1 < µ < 10, in order to equalise reflections occurring on the facade exterior and the facade rear side relative to one another.

2. Façade cover according to Claim 1, **characterised in that** the façade layer (1) uses ceramic material or glass as the structural material.

3. Facade cover according to one of the previous claims, **characterised in that** the facade layer (1) uses brick, natural stone or sandstone as the structural material.

4. Facade cover according to one of the previous claims, **characterised in that** the facade layer (1) uses fibre concrete as the structural material.

5. Facade cover according to one of the previous claims, **characterised in that** the facade layer (1) uses as the structural material a pressed laminated material made from cellulose material impregnated with synthetic resins and compressed.

6. Facade cover according to one of the previous claims, **characterised in that** the electrical resistor layer (2) comprises a nonwoven fabric provided with an electrically conductive material or a textile fabric.

7. Facade cover according to one of the previous claims, **characterised in that** the electrical resistor layer (2) comprises a nonwoven fabric incorporating soot.

8. Facade cover according to one of the previous claims, **characterised in that** the electrical resistor layer (2) is a nonwoven fabric comprising electrically conductive fibres.

9. Façade cover according to one of the previous claims, **characterised in that** the electrical resistor layer (2) comprises a film made of electrically conductive and/or magnetic material particles.

10. Facade cover according to one of the previous claims, **characterised in that** the facade layer (1) comprises a sandwich element.

11. Façade cover according to at least one of the above claims, **characterised in that** heat-insulating material (4) is arranged in the region between the building wall (6) and the facade layer (1).

12. Facade cover according to at least one of the previous claims, **characterised in that** metal cassettes (5) are mounted on the building wall (6) for accommodating and holding insulating material (4).

## Revendications

1. Structure de façade de bâtiments pour la réflexion d'ondes radar, comportant une couche de façade disposée à distance du mur du bâtiment et une couche électriquement résistante disposée dans la région de la couche de façade,
**caractérisée en ce que**
la couche résistante (2) est installée sur le côté intérieur de la couche de façade (1) et présente une résistance de surface comprise dans la plage de 10 à 300 Ω/□, et
**en ce que** la couche de façade (1) présente une épaisseur (D) comprise entre 15 et 80 mm et une constante diélectrique 3 < ε < 100 ainsi qu'une perméabilité 1 < µ < 10, pour compenser les unes par rapport aux autres les réflexions qui ont lieu sur le côté extérieur de la façade et sur le côté arrière de la façade.

2. Structure de façade selon la revendication 1, **caractérisée en ce que** l'on utilise comme matériau de construction de la couche de façade (1) un matériau céramique ou du verre.

3. Structure de façade selon l'une des revendications précédentes, **caractérisée en ce que** l'on utilise comme matériau de construction pour la couche de façade (1) de la brique, de la pierre naturelle ou de la pierre de grès.

4. Structure de façade selon l'une des revendications précédentes, **caractérisée en ce que** l'on utilise comme matériau de construction pour la couche de façade (1) un ciment additionné de fibres.

5. Structure de façade selon l'une des revendications précédentes, **caractérisée en ce que** l'on utilise comme matériau pour la couche de façade (1) un matériau en couches stratifiées constituées d'un matériau de cellulose imprégné de résine synthétique et comprimé.

6. Structure de façade selon l'une des revendications précédentes, **caractérisée en ce que** la couche électriquement résistante (2) est constituée d'un feutre ou d'un produit plat textile doté d'un matériau électriquement conducteur.

7. Structure de façade selon l'une de revendications précédentes, **caractérisée en ce que** la couche électriquement résistante (2) est formée par un feutre dans lequel est incorporé de la suie.

8. Structure de façade selon l'une des revendications précédentes, **caractérisée en ce que** la couche électriquement résistante (2) est un feutre de fibres électriquement conductrices.

9. Structure de façade selon l'une des revendications précédentes, **caractérisée en ce que** la couche électriquement résistante (2) est constituée d'un film de particules de matière électriquement conductrice et/ou de matière magnétique.

10. Structure de façade selon l'une des revendications précédentes, **caractérisée en ce que** la couche de façade (1) est formée d'un élément en sandwich.

11. Structure de façade selon au moins l'une des revendications précédentes, **caractérisée en ce qu'**un matériau d'isolation thermique (4) est disposé entre le mur (6) du bâtiment et la couche de façade (1).

12. Structure de façade selon au moins l'une des revendications précédentes, **caractérisée en ce que** des cassettes métalliques (5) servant à recevoir et retenir un matériau isolant (4) sont installées contre le mur (6) du bâtiment.
